Europäisches Patentamt

European Patent Office

Office européen des brevets

(11) Publication number: **0 089 833**
**B1**

(12) **EUROPEAN PATENT SPECIFICATION**

(45) Date of publication of patent specification: **11.01.89**

(51) Int. Cl.⁴: **G 11 C 8/00**, G 11 C 11/40

(21) Application number: **83301535.7**

(22) Date of filing: **18.03.83**

(54) Semiconductor memory circuit including a charge absorbing circuit.

(30) Priority: **19.03.82 JP 43978/82**
**27.09.82 JP 166711/82**

(43) Date of publication of application:
**28.09.83 Bulletin 83/39**

(45) Publication of the grant of the patent:
**11.01.89 Bulletin 89/02**

(84) Designated Contracting States:
**DE FR GB**

(56) References cited:
**EP-A-0 025 316**
**EP-A-0 087 919**
**IBM TECHNICAL DISCLOSURE BULLETIN, vol.
23, no. 8, January 1981, pages 3747-3748, New
York, US; W. KLEIN et al.: "High-speed decoder
circuit with low power requirements for clock-
controlled semiconductor storages"**
**IBM TECHNICAL DISCLOSURE BULLETIN, vol.
23, no. 4, September 1980, pages 1475-1476,
New York, US; G. BOUDON et al.: "Memory
power down circuit and word line
decoder/driver under low power supply"**

(73) Proprietor: **FUJITSU LIMITED**
**1015, Kamikodanaka Nakahara-ku
Kawasaki-shi Kanagawa 211 (JP)**

(72) Inventor: **Kitano, Kouichi
29-9 Higashimukojima 6-chome
Sumida-ku Tokyo 131 (JP)**
Inventor: **Isogai, Hideaki
4-11-13 Minamisawa Higashikurume-shi
Tokyo 180-03 (JP)**

(74) Representative: **Rackham, Stephen Neil et al
GILL JENNINGS & EVERY 53-64 Chancery Lane
London WC2A 1HN (GB)**

Courier Press, Leamington Spa, England.

## Description

In recent years, a variety of semiconductor memory circuits have been proposed. The present invention especially refers to the static-type semi-conductur memory circuits comprising saturation-type memory cells and incorporating delay circuits. The delay circuits are connected to word lines to improve both the rising and falling characteristics of the word lines and hold lines. The presence of such delay circuits makes it possible to achieve a high speed transition of the word lines between a selected state and a nonselected state. This results in a very short access time for the memory cells. Further, such time constant circuits have an advantage in that the short access time is obtained without increasing the memory cell current, that is, without increasing the power consumption.

However, there is a problem with such delay circuits in that an undesired double selection of word lines tends to occur.

Our earlier EP—A—87919 (representing prior art according to Art. 54(3), EPC) discloses a semiconductor memory circuit comprising a plurality of word lines; a plurality of hold lines; a plurality of memory cells each connected to a pair of bit lines and driven by a corresponding word line and hold line; a plurality of hold current sources operable always to pass a hold current through each hold line; a common additional hold current source operable cooperating with a delay circuit, to pass or not pass an additional hold current through a hold line during its transition from a selected state to a nonselected state or during a transition from the nonselected state to the selected state of its corresponding word line, and a charge absorbing circuit for each of the word lines.

According to this invention a semiconductor memory circuit comprises a plurality of word lines connected to bases of npn transistors; a plurality of hold lines; a plurality of memory cells each connected to a pair of bit lines and driven by a corresponding word line and hold line; a plurality of hold current sources operable always to pass a hold current through each hold line; a common additional hold current source; a plurality of delay circuits including said first npn transistor with its base connected to its respective word line; a second transistor through which the hold current flows from its respective hold line to the common additional hold current source, the base of the second transistor being controlled by the output of the first transistor cooperating with the delay circuit and operable to pass or not pass an additional hold current through a hold line during its transition from a selected state to a nonselected state or during a transition from the nonselected state to the selected state of its corresponding word line; and a charge absorbing circuit for each of the word lines, the charge absorbing circuit being operable to absorb a current induced by a voltage greater than the nonselected voltage occuring in a word line soon after it is switched from its selected state to its nonselected state.

A number of embodiments of semiconductor memory circuits in accordance with this invention will now be described and contrasted with the prior art with reference to the accompanying drawings, in which:—

Figure. 1 is a circuit diagram of a conventional static-type semiconductor memory circuit;

Figure 2 depicts a waveform diagram of signals appearing in the circuit shown in Figure 1;

Figure 3 is a circuit diagram of a typical saturation-type memory cell;

Figure 4 is a circuit diagram of a first embodiment of the present invention;

Figure 5 is a circuit diagram of a second embodiment of the present invention;

Figure 6 is a detailed circuit diagram of one example of the current source ΔI shown in Figure 5;

Figure 7A is a circuit diagram of a third embodiment of the present invention;

Figure 7B is a circuit diagram of a modification of the third embodiment;

Figure 8 is a circuit diagram of a fourth embodiment of the present invention;

Figure 9 is a circuit diagram of a fifth embodiment of the present invention; and

Figure 10 is a circuit diagram of a sixth embodiment of the present invention.

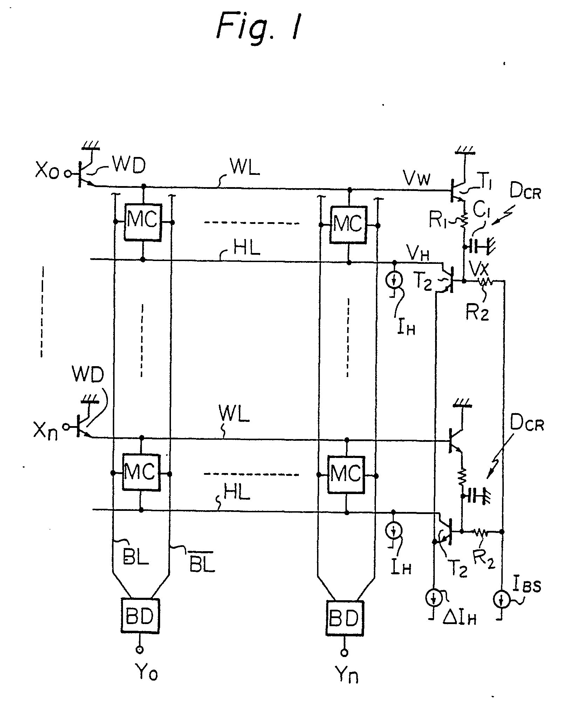

Figure 1 is a circuit diagram of a static-type semiconductor memory circuit to which the present invention is adapted. In Fig. 1, the symbol MC corresponds to a memory cell; WL to a word line; HL to a hold line; BL and $\overline{BL}$ to a pair of bit lines; WD to a word driver; BD to a bit line driver; $I_H$ to a hold current source; and $D_{CR}$ to a delay circuit. The delay circuits $D_{CR}$ exist for word lines WL. Each delay circuit $D_{CR}$ comprises: a first transistor $T_1$ which detects the voltage level change of the word line; a first resistor $R_1$ and a first capacitor $C_1$, together comprising a time constant circuit; and a second transistor $T_2$ which receives, at its base, the output from the time constant circuit $(C_1 R_1)$. Each second transistor is connected, at its collector, to the hold line HL and, at its emitter, to a common additional hold current source $\Delta I_H$. The second transistors $T_2$ are commonly connected, at their emitters, to the current source $\Delta I_H$. Thereby, a so-called current switch is formed. On the other hand, the second transistors $T_2$ are commonly connected, at their bases, to a common bias current source $I_{BS}$, through second resistors $R_2$.

A detailed explanation of the operation of the delay circuit $D_{CR}$ is mentioned in the specification of United States of America 4,370,736 (=EP—A—25316), so only a brief explanation is given here. Of many second transistors $T_2$, forming part of the previously mentioned current switch, only one transistor $T_2$ is turned on, when the transistor $T_2$ has the highest among the base voltage levels of these transistors $T_2$. Therefore, an additional hold current is absorbed by the source $\Delta I_H$ through the transistor $T_2$ now conductive. In this case, the

base voltage level $V_x$ of the transistor $T_2$ changes after the change of the voltage level $V_W$ of the word line WL with a predetermined time delay. Therefore, the second transistor $T_2$ is turned on not immediately after the voltage change of the word line WL, but with the above-mentioned time delay.

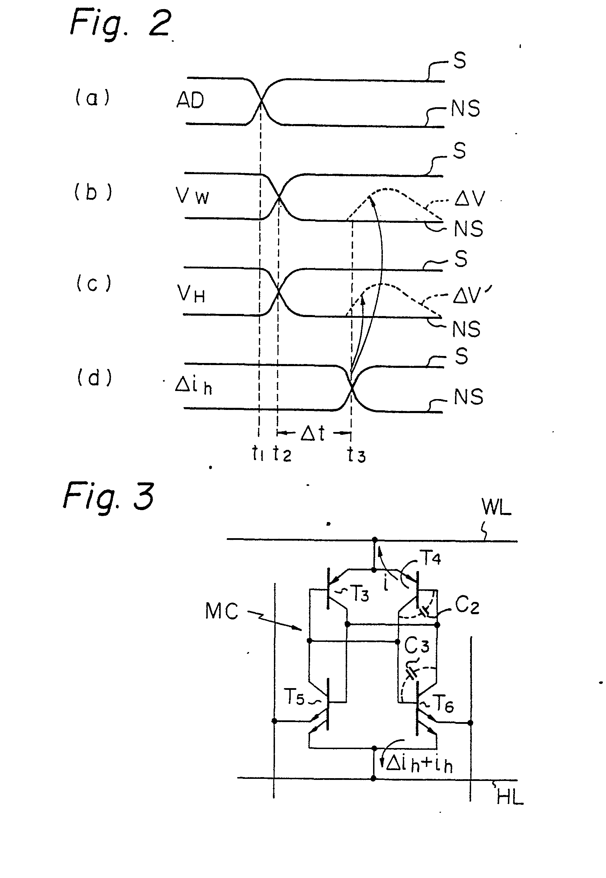

Figure 2 depicts waveforms of signals appearing in the circuit of Fig. 1. Row (a) represents a change of address selection signal indicated as $X_0$ through $X_n$ in Fig. 1. The address change occurs at time t1. Row (b) represents a change of the word line voltage level $V_W$, which occurs at time t2 close to t1. Row (c) represents a change of the hold line voltage level $V_H$, which follows immediately after the time t2. Row (d) represents a change of the additional hold current $\Delta i_h$ absorbed by the additional hold current source $\Delta I_H$ flowing through the conductive second transistor $T_2$, which occurs at time t3 with a delay of time $\Delta t$ after the time t2 due to the presence of the time constant circuit. In rows (a) through (d), the symbol "S" indicates a selection state and "NS" a nonselection state.

Thus, the additional hold current $\Delta i_h$ does not start flowing through the hold line HL until the word line voltage level $V_W$ completely rises to its saturation level. This means that the word line is allowed to carry a relatively light load during the transition from the nonselection state to the selection state. On the other hand, during the transition from the selection state to the nonselection state, the additional hold current $\Delta i_h$ continues flowing through the hold line for a while ($\Delta t$) even after the word driver WD stops supplying a current due to the address change. Consequently, the change of the word line voltage level, that is, the transition from the selection state to the nonselection state and vice versa, is completed very quickly. In addition, referring especially to the transition from the selection state to the nonselection state, the current $\Delta i_h$ is also stopped very quickly. This is because the current $\Delta i_h$ is produced by the current switch comprised of the second transistor $T_2$ and the current source $\Delta I_H$, which current switch operates usually with high gain. However, it is very important to note that such a quick stoppage of the current $\Delta i_h$ induces an undesired increase in the word line voltage (also the hold line voltage), shown as $\Delta V$ and $\Delta V'$ of broken lines in rows (b) and (c) of Fig. 2. Such undesired voltage increases $\Delta V$ and $\Delta V'$ result in double selection of the word lines.

The reason why such voltage increases $\Delta V$ and $\Delta V'$ are generated is not clearly understood, but is considered, in reference to Figs. 2 and 3, to be as follows: Figure 3 is a circuit diagram of a typical saturation-type memory cell. In Fig. 3, members the same as those of Fig. 1 are represented by the same reference symbols (same for later figures). Reference symbols $T_3$ and $T_4$ represent load transistors of the pnp type. Reference symbols $T_5$ and $T_6$ represent driver transistors of the npn and multiemitter type. Assuming that the transistors

of the transistor $T_6$ side are now conductive, the current $\Delta i_h$ for the current source $\Delta I_H$ of Fig. 1 and also the current $i_h$ for the current source $I_H$, i.e. $\Delta i_h + i_h$, flow in the memory cell MC into the hold line HL via the emitter and base of the transistor $T_4$ and the collector and emitter of the transistor $T_6$. At this, charges are stored in a junction capacitor $C_2$ between the collector and base of the transistor $T_4$ and also in a junction capacitor $C_3$ between the collector and base of the transistor $T_6$. In this case, the junction capacitance of $C_2$ and the junction capacitance of $C_3$ are variable in accordance with the variation of the current as $\Delta i_h + i_h$. To be specific, if this current is large, each of the junction capacitances is also large and vice versa. Accordingly, when the quick stoppage of the current $\Delta i_h$ occurs due to the high gain of the current switch ($T_2$, $\Delta I_H$), the junction capacitances of $C_2$ and $C_3$ are also quickly made small simultaneously. Therefore, these junction capacitors $C_2$ and $C_3$, which now have small junction capacitances, can no longer hold the charges, as they are, stored therein, and, thereby, surplus charges are produced therefrom. These surplus charges may, on one hand, fade away through recombination and, on the other hand, travel somewhere. The thus traveling surplus charges are represented by a current i of Fig. 3 flowing into the word line WL. The current i induces the increase in the word line voltage, as indicated by symbol $\Delta V$ in row (b) of Fig. 2. At the same time, the increase $\Delta V$ induces an increase $\Delta V'$ in the hold line voltage via the memory cell MC, as shown in row (c) of Fig. 2.

Even though the value of the current i itself is considerably small, the value of the voltage increase $\Delta V$ (also $\Delta V'$) is relatively high. This is because the impedance of the word line WL itself is considerably high.

Thus, the voltage increase $\Delta V$ ($\Delta V'$) induces, in the worst case, undesired double selection between one word line which is going to be changed from the selection state to the nonselection state and another word line which is going to be changed from the nonselection state to the selection state. Even if such a worst case is not created, deterioration of the write operation characteristic may occur, because an undesired branching of the write current takes place in the two word lines interchanging the selection and nonselection states therebetween.

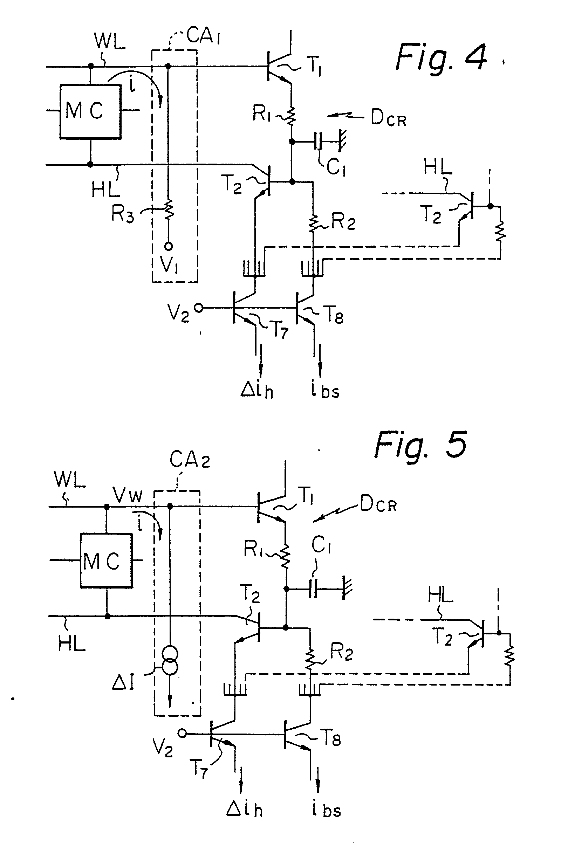

Figure 4 is a circuit diagram of a part of the semiconductor memory circuit cooperating with a charge absorbing circuit according to a first embodiment of the present invention. The first embodiment is illustrated as a charge absorbing circuit $CA_1$ which is simply constructed by a third resistor $R_3$. The resistor $R_3$ is connected, at one end, to the word line WL, while it receives, at the other end, a first constant voltage $V_1$. The level of the voltage $V_1$ is set to the same voltage level as the word line appearing in the nonselection state. Accordingly, the current i, due to the traveling surplus charges, is absorbed by a voltage difference across the resistor $R_3$ identical to the voltage $\Delta V$. At the same time, the voltage increase $\Delta V$ can

be suppressed by the discharge of the current i. In other words, the impedance of the word line WL is lowered by the resistor $R_3$.

Transistors $T_7$ and $T_8$ receive, at their bases, a second constant voltage $V_2$ so as to form the common additional hold current source $\Delta I_H$ producing the current $\Delta i_h$ and the common bias current source $I_{BS}$ producing the current $i_{bs}$, respectively, both shown in Fig. 1.

Figure 5 is a circuit diagram of a part of the semiconductor memory circuit cooperating with a charge absorbing circuit according to a second embodiment of the present invention. The second embodiment is illustrated as a charge absorbing circuit $CA_2$ which utilizes a current source $\Delta I$. The current flowing through the source $\Delta I$ is not constant, but variable in accordance with the variation of the word line voltage $V_W$. Therefore, when the voltage $V_W$ rises along with the voltage increase of $\Delta V$, the current i, due to the traveling surplus charges, can immediately be absorbed by the source $\Delta I$. Thus, the voltage increase $\Delta V$ can be suppressed.

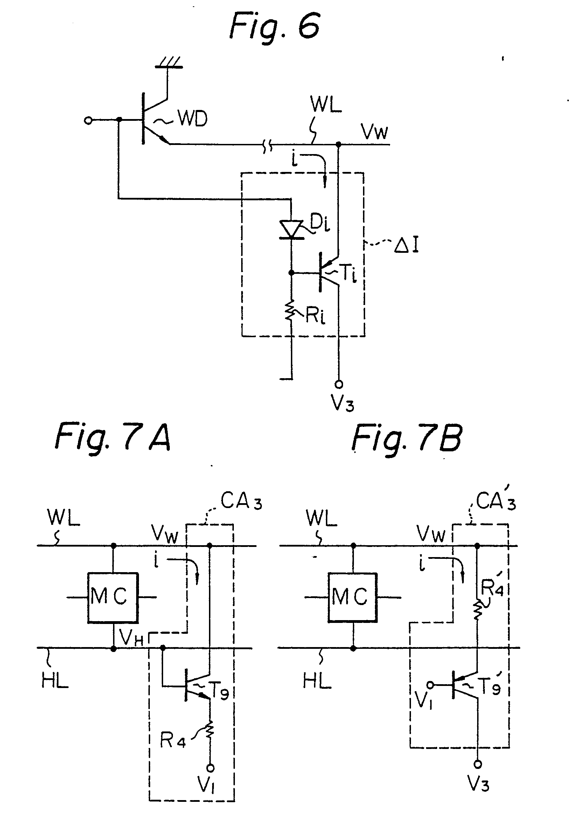

Figure 6 is a detailed circuit diagram of one example of the current source $\Delta I$ shown in Fig. 5. The current source $\Delta I$ is comprised at least of a transistor $T_i$, a diode $D_i$, and a resistor $R_i$. The diode $D_i$ functions as a level shifter. In the case of the time t3 of row (b) in Fig. 2, the base voltage of the word driver WD is the low level and, accordingly, the base voltage of the transistor $T_i$ is the low level. On the other hand, the word line voltage $V_W$ rises with the voltage increase of $\Delta V$. Then, the transistor $T_i$ is fully turned on, so that the current i can be absorbed into a voltage source of $V_3$.

Figure 7A is a circuit diagram of a part of the semiconductor memory circuit cooperating with a charge absorbing circuit according to a third embodiment of the present invention. The third embodiment is illustrated as a charge absorbing circuit $CA_3$. Transistor $T_9$ of the npn type is connected at its collector to the word line WL and at its base to the hold line HL. The emitter thereof receives the first constant voltage $V_1$ via a fourth resistor $R_4$. Since, as previously mentioned, the hold line voltage $V_H$ increases along with the increase of the word line voltage $V_W$, the transistor $T_9$ is turned on when the voltage increase $\Delta V$ takes place. Thus, the voltage $V_W$ is increased. At this time, the current i can be absorbed toward the voltage source of $V_1$ through the transistor $T_9$, now on.

Figure 7B is a circuit diagram of a modification of the charge absorbing circuit $CA_3$ in Fig. 7A. The modified example is illustrated as a charge absorbing circuit $CA_3'$ comprised of a resistor $R_4'$ and a transistor $T_9'$ of the pnp type, opposite to that of the transistor $T_9$. The collector of the transistor $T_9'$ is a negative constant voltage source or a constant voltage source of $V_3$, as is the transistor $T_i$ of Fig. 6. The emitter thereof is connected to the word line WL. The base thereof is not connected to the hold line HL, as in the circuit of Fig. 7A, but receives the first constant

voltage $V_1$. If the word line voltage $V_W$ rises with the voltage increase $\Delta V$, the transistor $T_9'$ is turned on. Then the current i starts flowing through the transistor $T_9'$, now conductive.

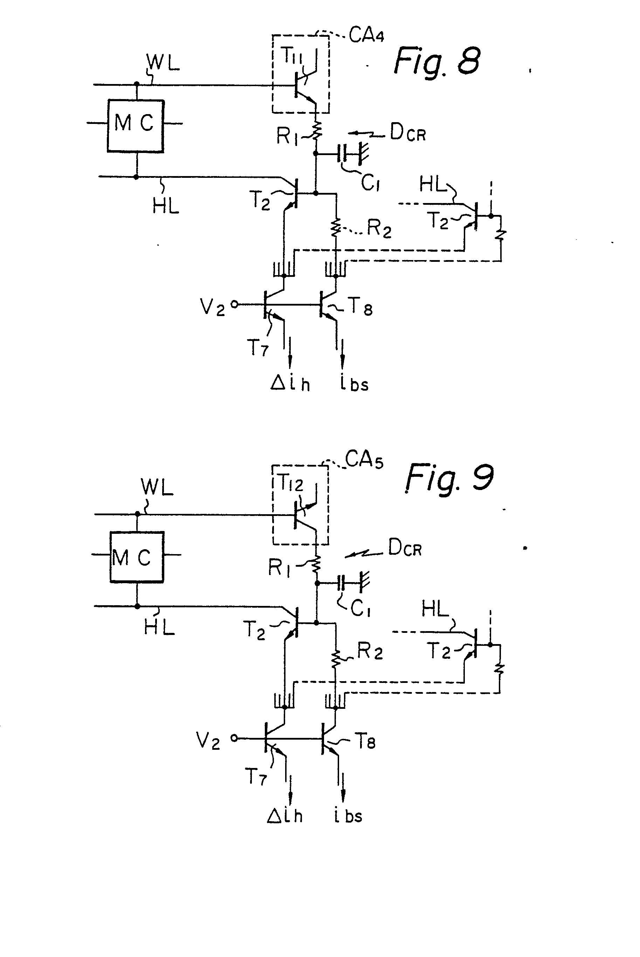

Figure 8 is a circuit diagram of a part of the semiconductor memory circuit cooperating with a charge absorbing circuit according to a fourth embodiment of the present invention. The fourth embodiment utilizes a transistor having a low current amplification factor $\beta$ as a charge absorbing circuit. The base is connected to the word line WL, while the emitter may be connected to an appropriate current source. When the transistor is turned on, a relatively large base current flows from the word line WL to its emitter, because it has a low current amplification factor $\beta$. Therefore, the transistor has sufficient capability for absorbing the current i induced by the voltage increase $\Delta V$ from the word line, and, thereby, the charge absorbing circuit can be realized. In the fourth embodiment, such a charge absorbing circuit is referenced by the symbol $CA_4$ and is preferably constructed as common to the aforesaid first transistor $T_1$. Thus, a first transistor $T_{11}$ of low current amplification is used as both the first transistor $T_1$ and the charge absorbing circuit $CA_4$.

Such a low current amplification transistor can be fabricated in such a manner as to form a deep base diffusion region during the production process of the semiconductor memory device.

Figure 9 is a circuit diagram of a part of the semiconductor memory circuit cooperating with a charge absorbing circuit according to a fifth embodiment of the present invention. The basic concept behind the fifth embodiment is the same as that of the above-mentioned fourth embodiment. The embodiments, however, differ in that a transistor corresponding to the first transistor $T_{11}$ of Fig. 8 is realized in the fifth embodiment by an inverse transistor. That is, in Fig. 9, the charge absorbing circuit $CA_5$ of the fifth embodiment is comprised of the inverse transistor $T_{12}$. The term "inverse transistor" means that a region which would usually act as an emitter is used inversely as a collector, and, similarly, a region which would usually act as a collector is used inversely as an emitter. Such an inversion between the emitter and collector is easily achieved merely by interchanging conductors during the production process of the semiconductor memory device. That is, a first conductor which would usually be connected to the emitter region is inversely connected to the collector region, and, similarly, a second conductor which would usually be connected to the collector region is inversely connected to the emitter region.

The reason why the inverse transistor $T_{12}$ provides a low current amplification factor $\beta$, as the transistor $T_{11}$ of Fig. 8, is that it has a lower efficiency of injection and a lower efficiency of collection. The lower injection efficiency is due to the fact that the inverse transistor can no longer function as a drift transistor. This is because an electric field, which is oriented opposite to that of the drift transistor, is applied onto a transition path of electrons traveling from a usual collector region to a usual emitter. The lower collection efficiency is that electrons traveling from the usual collector region toward the usual emitter region partly leak into the base region, because the usual collector region has a wider area than the usual emitter region.

Thus, the transistor $T_{12}$ has sufficient capability for absorbing the current i induced by the voltage increase $\Delta V$ from the word line WL, and, thereby, the charge absorbing circuit $CA_5$ can be realized, which is preferably constructed as common to the first transistor $T_1$. Thus, a first transistor $T_{12}$ of low current amplification is used as both the first transistor $T_1$ and the charge absorbing circuit $CA_5$.

Reviewing against the first through fifth embodiments, the charge absorbing circuit of each embodiment absorbs not only the current i to be suppressed, but also a charge current to be supplied to the word line during the transition from the nonselection state to the selection state. In this case, it would be preferable to absorb only the current i selectively and not the charge current, because, the charge current itself must not be drawn from the word line WL. If the charge current is unnecessarily drawn therefrom, it may cause increased power consumption in the device. However, it is important to know that such an increased power consumption is negligible. This is because the related charge current flows, at all times, into only the one selected word line, among the many word lines, from the selected word driver.

If necessary, however, it is possible to construct a charge absorbing circuit which does not absorb that charge current, but only the undesired current i. This, however, would complicate the construction of the charge absorbing circuit.

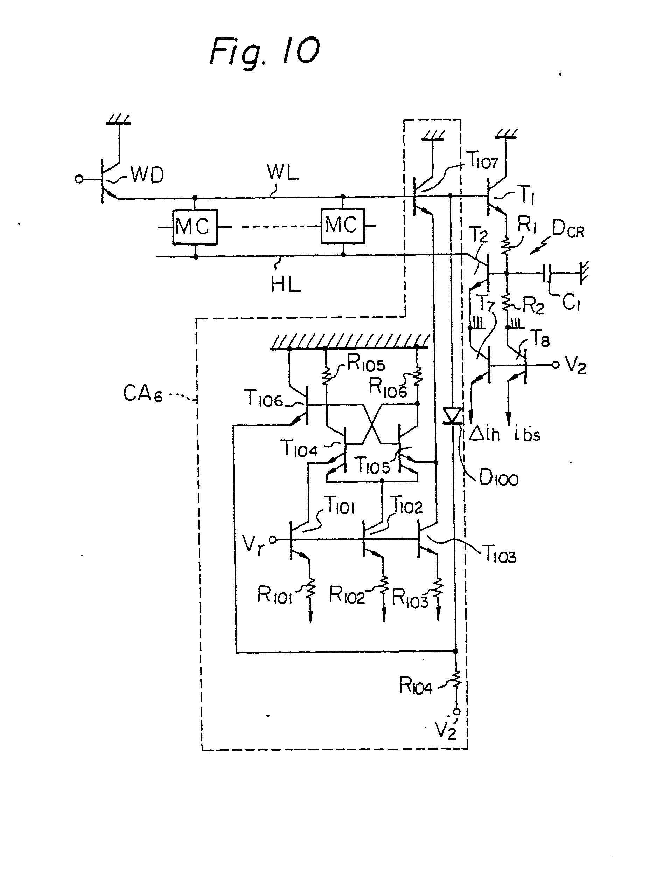

Figure 10 is a circuit diagram of a part of the semiconductor memory circuit cooperating with a charge absorbing circuit according to a sixth embodiment of the present invention. The sixth embodiment is illustrated as a charge absorbing circuit $CA_6$ which can absorb the current i only. In Fig. 10, each pair of transistor and resistor, such as $T_{101}$—$R_{101}$, $T_{102}$—$R_{102}$, $T_{103}$—$R_{103}$, forms a constant current source. Symbol $V_r$ denotes a voltage for activating these constant current sources. Transistors $T_{104}$ and $T_{105}$, together with resistors $R_{105}$ and $R_{106}$, form a flip-flop. Symbol $V_2'$ denotes a voltage having substantially the same level as the second constant voltage $V_2$, but a slightly higher level than $V_2$ by the value of $V_F$, which is a forward voltage of a diode $D_{100}$. The transistor $T_{105}$ and a transistor $T_{107}$ form emitter-coupled transistors. The operation is as follows. During the selection state, the base voltage of the transistor $T_{107}$ becomes higher than that of the transistor $T_{105}$. Therefore, the transistor $T_{105}$ is turned off, while, inversely, the transistor $T_{104}$ is turned on, since they perform a flip flop operation. The transistor $T_{106}$ is then turned on due to a voltage drop across the resistor $R_{105}$ induced by the conductive transistor $T_{104}$. A current produced by the conductive transistor $T_{106}$ flows toward the voltage source of $V_2'$ through a resistor $R_{104}$. This current creates a voltage drop across the resistor $R_{104}$, and, thereby, the voltage level at the upper end of the resistor $R_{104}$ becomes higher than the voltage level of $V_2'$ by the amount of the voltage drop. Thus, the diode $D_{100}$ is changed to a cut-off state now, and, thereby, no current flows from the word line WL to the voltage source of $V_2'$. In conclusion, neither the aforesaid charge current nor the current i is drawn from the word line during the selection state.

Contrary to the above, during the nonselection state, the base voltage of the transistor $T_{107}$ becomes lower than that of the transistor $T_{105}$. Therefore, the transistor $T_{105}$ is turned on, while, inversely, the transistor $T_{104}$ is turned off, since they perform a flip flop operation. Since the transistor $T_{104}$ is turned off, the transistor $T_{106}$ is then turned off due to no voltage drop across the resistor $R_{105}$. Therefore, a current which would be produced by the conductive transistor $T_{106}$ stops flowing toward the voltage source of $V_2'$ through a resistor $R_{104}$. This current stop does not create a voltage drop across the resistor $R_{104}$. Therefore, the voltage level at the upper end of the resistor $R_{104}$ becomes the same as the voltage level of $V_2'$. This means that the diode $D_{100}$ is not fully in the cut-off state, but is liable to change into the conductive state if a slight voltage is induced in the word line WL. Under such circumstances, if the voltage increase $\Delta V$ occurs in the word line WL, the diode $D_{100}$ is necessarily made conductive. Thus, the current i is absorbed by the voltage source of $V_2'$. In the present state, since the voltage level of $V_2'$ is preset to be higher than the voltage level of $V_2$ by the value of $V_F$, for example 400 mV, i.e., the diode $D_{100}$ is fully biased reversely, no current is drawn from the word line WL so long as the word line voltage is maintained at its nominal level, i.e., $V_2$. In conclusion, only the current i is drawn from the word line only during the nonselection state.

As mentioned above in detail, according to the present invention, neither the double selection nor the erroneous write current flow occur in the semiconductor memory circuit.

## Claims

1. A semiconductor memory circuit comprising a plurality of word lines (WL) connected to bases of npn transistors $(T_1)$; a plurality of hold lines (HL); a plurality of memory cells (MC) each connected to a pair of bit lines (BL, $\overline{BL}$), and driven by a corresponding word line (WL) and hold line (HL); a plurality of hold current sources $(I_H)$ operable always to pass a hold current through each hold line (HL); a common additional hold current source $(\Delta I_H)$; a plurality of delay circuits (DCR) including said first npn transistor $(T_1)$ with its base connected to its respective word line; a second transistor $(T_2)$ through which the hold current flows from its respective hold line (HL) to the common additional hold current source $(\Delta I_H)$,

the base of the second transistor ($T_2$) being controlled by the output of the first transistor ($T_1$) cooperating with the delay circuit ($D_{CR}$) and operable to pass or not pass an additional hold current through a hold line (HL) during its transition from a selected state to a nonselected state or during a transition from the nonselected state to the selected state of its corresponding word line (WL); and a charge absorbing circuit ($CA_1$ to $CA_6$) for each of the word lines (WL), the charge absorbing circuit ($CA_1$ to $CA_6$) being operable to absorb a current induced by a voltage ($\Delta V$) greater than the nonselected voltage (NS) occurring in a word line (WL) soon after it is switched from its selected state to its nonselected state.

2. A semiconductor memory circuit according to claim 1, wherein each charge absorbing circuit ($CA_1$ Figure 4) comprises a resistor ($R_3$) connected between its corresponding word line (WL), and a voltage source ($V_1$) having a constant voltage level which is the same as the voltage level of the word line in its nonselected state.

3. A semiconductor memory circuit according to claim 1, wherein each charge absorbing circuit ($CA_2$ Figure 5) comprises a current source ($\Delta I$) for drawing a current from its corresponding word line (WL) at least at the time that the voltage increase ($\Delta V$) occurs through the current source ($\Delta I$) varies in accordance with the variation in the voltage (VW) on the corresponding word lines (WL).

4. A semiconductor memory circuit according to claim 1, wherein the charge absorbing circuit ($CA_3$, Figure 7A) comprises a transistor of the npn type ($T_9$) which has its collector connected to the corresponding word line and its base connected to its corresponding hold line ($H_2$), its emitter receiving, via a resistor ($R_4$) a constant voltage ($V_1$) which is the same as the voltage level of the corresponding word line (WL) in its nonselected state.

5. A semiconductor memory circuit according to claim 1, wherein each charge absorbing circuit ($CA_3$ Figure 7B) comprises a transistor of pnp type ($T_9'$) having its emitter connected to its corresponding word line (WL), its base receiving a constant voltage ($V_1$) which is the same as the voltage level of the corresponding word line (WL) in its nonselected state, the collector of the transistor ($T_9'$) being connected to a constant voltage source ($V_3$).

6. A semiconductor memory circuit according to claim 1, wherein each charge absorbing circuit ($CA_4$ Figure 8) comprises a transistor ($T_{11}$) having a low current amplification factor, the base of the transistor ($T_{11}$) being connected to its corresponding word line (WL) and its emitter being connected to a current source, the transistor ($T_{11}$) also forming said first transistor ($T_1$ Figure 1) of the delay circuit ($D_{CR}$).

7. A semiconductor memory circuit according to claim 1, wherein each charge absorbing circuit ($CA_5$, Figure 9) comprises an inverse transistor ($T_{12}$) with the region which would usually act as its emitter being used inversely as its collector and, similarly, the region which would usually act as its collector used inversely as its emitter, the base of the inverse transistor ($T_{12}$) being connected to its corresponding word line and its emitter being connected to a current source, the transistor ($T_{12}$) also forming said first transistor ($T_1$, Figure 1) of the delay circuit ($D_{CR}$).

8. A semiconductor memory circuit according to claim 1, wherein each charge absorbing circuit ($CA_6$, Figure 10) comprises a diode ($C_{100}$) connected at its anode to its corresponding word line (WL), a resistor ($R_{104}$) connected in series with the cathode of the diode ($D_{100}$) and a constant voltage source ($V_2'$) and a control circuit connected to the node between the cathode of the diode ($D_{100}$) and resistor ($R_{104}$) and which controls whether or not to pass a current through the resistor ($R_{104}$) by cooperating with a transistor ($T_{107}$) an emitter of which is connected to the control circuit, a base of which is connected to the corresponding word line (WL) and a collector of which is connected to a power source.

**Patentansprüche**

1. Halbleiterspeichervorrichtung mit: einer Vielzahl von Wortleitungen (WL), die mit Basen von npn-Transistoren ($T_1$) verbunden sind; einer Vielzahl von Halteleitungen (HL); einer Vielzahl von Speicherzellen (MC), die jeweils mit einem Paar von Bitleitungen (BL, $\overline{BL}$) verbunden und durch eine entsprechende Wortleitung (WL) und eine Halteleitung (HL) getrieben werden; einer Vielzahl von Haltestromquellen ($I_H$), die jeweils betreibbar sind, um einen Haltestrom durch jede Halteleitung zu führen; einer gemeinsamen zusätzlichen Haltestromquelle ($\Delta I_H$); einer Vielzahl von Verzögerungsschaltungen (DCR), einschließlich des genannten ersten npn-Transistors ($T_1$), der mit seiner Basis mit seiner entsprechenden Wortleitung verbunden ist; einem zweiten Transistor ($T_2$), durch den der Haltestrom von seiner jeweiligen Halteleitung (HL) zu der gemeinsamen zusätzlichen Haltestromquelle ($\Delta I_H$) fließt, wobei die Basis des zweiten Transistors ($T_2$) durch den Ausgang des ersten Transistors ($T_1$) gesteuert wird, der mit der Verzögerungsschaltung ($D_{CR}$) zusammenwirkt, und betreibbar ist, um einen zusätzlichen Haltestrom durch eine Halteleitung (HL) hindurchzuführen oder nicht hindurchzuführen, während seines Übergangs von einem ausgewählten Zustand in einen nicht ausgewählten Zustand oder während eines Übergangs von dem nicht ausgewählten Zustand zu dem ausgewählten Zustand seiner entsprechenden Wortleitung (WL); und einer Ladungsabsorptionsschaltung ($CA_1$ bis $CA_6$) für jede der Wortleitungen (WL), wobei die Ladungsabsorptionsschaltung ($CA_1$ bis $CA_6$) betreibbar ist, um einen Strom zu absorbieren, der durch eine Spannung ($\Delta V$) induziert wird, die größer als die nicht ausgewählte Spannungs (NS) ist, die in einer Wortleitung (WL) auftritt, kurz nachdem sie von ihrem ausgewählten Zustand in den nichtausgewählten Zustand umgeschaltet wird.

2. Halbleiterspeichervorrichtung nach Anspruch 1, bei der jede Ladungsabsorptionsschaltung (CA₁ Figur 4) einen Widerstand (R₃) umfaßt, der zwischen seiner entsprechenden Wortleitung (WL) und einer Spannungsquelle (V₁) verbunden ist, die einen konstanten Spannungspegel hat, welcher derselbe wie der Spannungspegel der Wortleitung in ihrem nicht ausgewählten Zustand ist.

3. Halbleiterspeichervorrichtung nach Anspruch 1, bei der jeder Ladungsabsorptionsschaltung (CA₂ Figur 5) eine Stromquelle (ΔI) umfaßt, um einen Strom von ihrer entsprechenden Wortleitung (WL) wenigstens zu der Zeit zu absorbieren, zu welcher der Spannungsanstieg (ΔV), der durch die Stromquelle (ΔI) auftritt, sich in Übereinstimmung mit der Änderung der Spannung (VW) auf den entsprechenden Wortleitungen ändert.

4. Halbleiterspeichervorrichtung nach Anspruch 1, bei der die genannte Ladungsabsorptionsschaltung (CA₃ Figur 7A) einen Transistor vom npn-Typ (T₉) umfaßt, dessen Kollektor mit der entsprechenden Wortleitung verbunden ist, und dessen Basis mit seiner entsprechenden Halteleitung (H₂) verbunden ist und dessen Emitter über einen Widerstand (R₄) eine konstante Spannung (V₁) empfängt, welche dieselbe wie der Spannungspegel der entpsrechenden Wortleitung (WL) in ihrem nicht ausgewählten Zustand ist.

5. Halbleiterspeichervorrichtung nach Anspruch 1, bei der jede Ladungsabsorptionsschaltung (CA₃ Figur 7B) einen Transistor vom pnp-Typ (T₉') umfaßt, dessen Emitter mit seiner entsprechenden Wortleitung (WL) verbunden ist, dessen Basis eine konstánte Spannungs (V₁) empfängt, welche dieselbe wie der Spannungspegel der entsprechenden Wortleitung (WL) in ihrem nicht ausgewählten Zustand ist, und bei der der Kollektor des Transistors (T₉') mit einer Konstantspannungsquelle (V₃) verbunden ist.

6. Halbleiterspeichervorrichtung nach Anspruch 1, bei der jede Ladungsabsorptionsschaltung (CA₄ Figur 8) einen Transistor (T₁₁) umfaßt, der einen niedrigen Stromverstärkungsfaktor hat, wobei die Basis des Transistors (T₁₁) mit seiner entsprechenden Wortleitung verbunden ist, sein Emitter mit einer Stromquelle verbunden ist und der Transistor (T₁₁) auch den ersten Transistor (T₁ Figur 1) der Verzögerungsschaltung (D_CR) bildet.

7. Halbleiterspeichervorrichtung nach Anspruch 1, bei der jeder Ladungsabsorptionsvorrichtung (CA₅ Figur 9) einen inversen Transistor (T₁₂) umfaßt, wobei der Bereich, der normalerweise als Emitter wirkt, invers als sein Kollektor versendet wird und, in ähnlicher Weise, der Bereich, der normalerweise als Kollektor wirkt, invers sals sein Emitter verwendet wird, und die Basis des inversen Transistors (T₁₂) mit seiner entsprechenden Wortleitung verbunden ist und sein Emitter mit einer Stromquelle verbunden ist, wobei der Transistor (T₁₂) auch den genannten ersten Transistor (T₁ Figur 1) der Verzögerungsschaltung (D_CR) bildet.

8. Halbleiterspeichervorrichtung nach Anspruch 1, bei der jede Ladungsabsorptionsschaltung (CA₆ Figur 10) eine Diode (D₁₀₀) umfaßt, die mit ihrer Anode mit ihrer entsprechenden Wortleitung (WL) verbunden ist, wobei ein Widerstand (R₁₀₄) in Reihe mit der Katode der Diode (D₁₀₀) und einer Konstantspannungsquelle (V₂') verbunden ist, und eine Steuerschaltung mit dem Knotenpunkt zwischen der Katode der Diode (D₁₀₀) und dem Widerstand (R₁₀₄) verbunden ist und steuert, ob oder nicht ein Strom durch den Widerstand (R₁₀₄) hindurchgeführt werden soll, durch Kooperation mit einem Transistor (T₁₀₇), von dem ein Emitter mit der Steuerschaltung verbunden ist, von dem eine Basis mit der entsprechenden Wortleitung (WL) verbunden ist, von dem ein Kollektor mit einer Energiequelle verbunden ist.

**Revendications**

1. Circuit de mémoire à semi-conducteur comportant plusieurs lignes de mots (WL) connectées aux bases de transistors NPN (T₁); plusieurs lignes de maintien (HL); plusieurs cellules de mémoire (MC) connectées chacune à une paire de lignes de bits (BL, B̄L̄) et attaquée par une ligne de mots (WL) et une ligne de maintien (HL) correspondantes; plusieurs sources de courants de maintien (I_H) ayant pour fonction de faire toujours passer un courant de maintien dans chaque ligne de maintien (HL); une source de courant de maintien supplémentaire commune (ΔI_H); plusieurs circuits à retard (DCR) comprenant ledit premier transistor NPN (T₁) avec sa base connectée à sa ligne de mots respective; un second transistor (T₂) par lequel le courant de maintien circule depuis sa ligne de maintien respective (HL) vers la source de courant de maintien supplémentaire commune (ΔI_H), la base du second transistor (T₂) étant commandée par la sortie du premier transistor (T₁) correspondant avec le circuit à retard (D_CR) et ayant pour fonction de faire passer ou de ne pas faire passer un courant de maintien supplémentaire par une ligne de maintien (HL) pendant sa transition d'un état sélectionné à un état non sélectionné ou pendant une transition de l'état non sélectionné à l'état sélectionné de sa ligne de mots correspondante (WL); et un circuit d'absorption de charge (CA₁ à CA₆) pour chacune des lignes de mots (WL), le circuit d'absorption de charge (CA₁ à CA₆) ayant pour fonction d'absorber un courant induit par une tension (ΔV) supérieure à la tension non sélectionnée (NS) apparaissant dans une ligne de mots (WL) aussitôt après son passage de son état sélectionné à son état non sélectionné.

2. Circuit de mémoire à semi-conducteur selon la revendication 1, dans lequel chaque circuit d'absorption de charge (CA₁, figure 4) comporte une résistance (R₃) connectée entre sa ligne de mots correspondante (WL) et une source de tension (V₁) ayant un niveau de tension constante qui est le même que le niveau de tension de la ligne de mots dans son état non sélectionné.

3. Circuit de mémoire à semi-conducteur selon la revendication 1, dans lequel chaque circuit d'absorption de charge (CA₂, figure 5) comporte une source de courant (ΔI) pour prélever un courant de sa ligne de mots correspondant (WL) au moins à l'instant où l'augmentation de tension ($\Delta V$) se produit par la source de courant ($\Delta I$), varie en fonction de la variation de tension (VW) sur les lignes de mots correspondantes (WL).

4. Circuit de mémoire à semi-conducteur selon la revendication 1, dans lequel le circuit d'absorption de charge ($CA_3$, figure 7A) comporte un transistor du type NPN ($T_9$) dont le collecteur est connecté à la ligne de mots correspondante et dont la base est connectée à la ligne de maintien correspondant ($H_2$), son émetteur recevant, par une résistance ($R_4$), une tension constante ($V_1$) qui est la même que le niveau de tension de la ligne de mots correspondante (WL) dans son état non sélectionné.

5. Circuit de mémoire à semi-conducteur selon la revendication 1, dans lequel chaque circuit d'absorption de charge ($CA_3$, figure 7B) comporte un transistor du type PNP ($T_{9'}$) dont l'émetteur est connecté à la ligne de mots correspondante (WL), dont la base reçoit une tension constante ($V_1$) qui est la même que le niveau de tension de la ligne de mots correspondante (WL) dans son état son sélectionné, le collecteur du transistor ($T_{9'}$) étant connecté à une source de tension constante ($V_3$).

6. Mémoire à semi-conducteur selon la revendication 1, dans lequel chaque circuit d'absorption de charge ($CA_4$, figure (8) comporte un transistor ($T_{11}$) ayant un faible facteur d'amplification en courant, la base du transistor ($T_{11}$) étant connecté à sa ligne de mots corspondante (WL) et son émetteur étant connecté à une source de courant,

le transistor ($T_{11}$) formant également ledit premier transistor ($T_1$, figure 1) du circuit à retard ($D_{CR}$).

7. Circuit de mémoire à semi-conducteur selon la revendication 1, dans lequel chaque circuit d'absorption de charge ($CA_5$, figure 9) comporte un transistor inverse ($T_{12}$) avec la région qui fonctionnerait habituellement comme son émetteur étant utilisée à l'inverse comme son collecteur et, de façon similaire, la région qui fonctionnerait habituellement comme son collecteur étant utilisée à l'inverse comme son émetteur, la base du transistor inverse ($T_{12}$) étant connectée à sa ligne de mots correspondante (WL) et son émetteur étant connectée à une source de courant, le transistor ($T_{12}$) formant également ledit premier transistor ($T_1$, figure 1) du circuit à retard ($D_{CR}$).

8. Circuit de mémoire à semi-conducteur selon la revendication 1, dans lequel chaque circuit d'absorption de charge ($CA_6$, figure 10) comporte une diode ($C_{100}$) connectée par son anode à sa ligne de mots correspondante (WL), une résistance ($R_{104}$) connectée en série avec la cathode de la diode ($D_{100}$) et une source de tension constante ($V_{2'}$) et un circuit de commande connecté au point commun entre la cathode de la diode ($D_{100}$) et la résistance ($R_{104}$) et qui commande si un courant doit passer ou non dans la résistance ($R_{104}$) en coopérant avec un transistor ($T_{107}$) dont un émetteur est connecté au circuit de commande, dont une base est connectée à la ligne de mots corresopndante (WL) et dont un collecteur est connecté à une source d'alimentation.

# Fig. 1

# Fig. 2

(a)  AD

(b)  Vw

(c)  VH

(d)  Δih

$$\Delta t$$

$t_1$ $t_2$ $t_3$

# Fig. 3

WL

T4

T3

C2

MC

C3

T5

T6

$\Delta i_h + i_h$

HL

2

*Fig. 4*

*Fig. 5*

3

*Fig. 6*

*Fig. 7A*

*Fig. 7B*

4

Fig. 8

Fig. 9

# Fig. 10